# EUROPEAN PATENT APPLICATION

(11) **EP 4 779 684 A1**
(43) Date of publication of application: **22.07.2026**
(21) Application number: 24884599.2
(22) Date of filing: 25.10.2024
(51) Int. Cl.: H01L 21/67, H01L 21/687

(54) **SEMICONDUCTOR PROCESSING SYSTEM AND SEMICONDUCTOR PROCESSING METHOD THEREFOR**

(30) Priority: 31.10.2023 CN 202311441265
(71) Applicant: Huaying Research Co., Ltd, Wuxi, Jiangsu 214000 (CN)
(72) Inventor: WEN, Sophia Ziying, Wuxi, Jiangsu 214000 (CN)
(74) Representative: Sun, Yiming
(86) International application number: PCT/CN2024/127385
(87) International publication number: WO 2025/092596

(57) **Abstract**

The present disclosure discloses a semiconductor processing system and a semiconductor processing method, comprising: a semiconductor processing device comprising a first chamber and a second chamber, wherein the chamber has a recessed groove, a first through-hole, and a second through-hole formed by being recessed from an inner wall surface of the corresponding chamber, wherein the surface of a semiconductor wafer abuts against the inner wall surface forming the recessed groove to form a sealed channel; a wafer transfer device comprising a robot and a control unit, wherein under the control of the control unit, the robot performs an angle adjustment operation on the semiconductor wafer; a drive and valve assembly that controls fluid flow into the sealed channel to process a selected region of the surface of the semiconductor wafer. Due to the robot performing the angle adjustment operation on the semiconductor wafer, this enables the extraction and detection of contaminant impurities from more selected regions of the semiconductor wafer.

## Description

### TECHNICAL FIELD

The present disclosure relates to the field of semiconductor technology, and in particular to a semiconductor processing system and a semiconductor processing method.

### BACKGROUND

As semiconductor dimensions further decrease, impurities contained in the wafer silicon material itself have become a requirement for quality control monitoring. However, current wafer contamination detection techniques are limited to extracting and detecting contamination on the wafer surface or performing destructive testing on the entire wafer material.

Each of Chinese patent applications 201210171681.9 and 201210088237.0 discloses a micro chamber processing device for processing a semiconductor wafer. The micro chamber processing device includes a first chamber and a second chamber. Driven by a driving device, the first and second chambers may relatively move between an open position for loading and/or unloading the semiconductor wafer, and a closed position for accommodating and processing the semiconductor wafer. A micro chamber is formed when the first and second chambers are disposed in the closed position, and the semiconductor wafer is placed in the micro chamber. Either or both of the first and second chambers may include one or more inlets, via which processing fluid may enter the micro chamber, and one or more outlets, via which the processing fluid may exit the micro chamber.

When the processing fluid enters the micro chamber through the inlet of the micro chamber to process the wafer, the fluid flow generally follows a fixed direction, but there is a lack of corresponding control mechanism to ensure the reaction degree between the processing fluid and the wafer. Existing technologies can ensure efficient extraction of surface contaminants when sufficient reaction time is provided during wafer surface contamination extraction and detection, however, when extracting and detecting impurities inside the wafer material, the required liquid etching of the wafer material leads to significant and uncontrollable variations in the depth of surface etching caused by the processing fluid due to different reaction degrees. Thus, when performing contamination detection on impurities inside the wafer material, detecting the processing fluid collected after the reaction can only obtain a qualitative situation of the overall approximate impurity contamination inside the wafer material, and it is impossible to accurately obtain a quantitative situation of impurity contamination within a given depth range inside the wafer material, and further it is impossible to obtain the distribution of impurity contamination at different depths inside the wafer.

For this purpose, Chinese Patent 201710078489.8 discloses a local wafer processing method. However, this method can only extract and detect contaminant impurities in a few local regions of the wafer, and there are many regions where extraction and detection of contaminant impurities cannot be processed.

It should be noted that the above description of the technical background is only for the convenience of clearly and completely explaining the technical solution of the present disclosure and for the convenience of understanding by the technical personnel in this field. It should not be considered that the above technical solutions are well known to those technical personnel in this field just because they are described in the background section of the present disclosure.

### SUMMARY

The present disclosure provides a semiconductor processing system and a semiconductor processing method, which can extract and detect contaminant impurities in more selected regions of a semiconductor wafer.

To achieve the above objective, the present disclosure provides a semiconductor processing system, comprising:
A semiconductor processing device, comprising: a first chamber; and a second chamber movable relative to the first chamber between an open position and a closed position, wherein when the second chamber is at the closed position relative to the first chamber, a micro chamber is formed between the first chamber and the second chamber, and a semiconductor wafer can be accommodated in the micro chamber, and when the second chamber is at the open position relative to the first chamber, the semiconductor wafer can be transferred into or out of the micro chamber; the first chamber and/or the second chamber comprises a recessed groove formed by being recessed from an inner wall surface of the corresponding chamber, a first through-hole penetrating from the exterior through the corresponding chamber to communicate with a first position of the recessed groove, and a second through-hole penetrating from the exterior through the corresponding chamber to communicate with a second position of the recessed groove; wherein when the second chamber is at the closed position relative to the first chamber and the semiconductor wafer is accommodated between the first chamber and the second chamber, the surface of the semiconductor wafer abuts against the inner surface forming the recessed groove, and the recessed groove forms a sealed channel by the blocking of the surface of the semiconductor wafer, the sealed channel communicating with the exterior through the first through-hole and the second through-hole;

A wafer transfer device comprising a robot and a control unit, wherein under the control of the control unit, the robot performs an angle adjustment operation on a semiconductor wafer located between the first chamber and the second chamber, the angle adjustment operation comprises: picking up the semiconductor wafer located between the first chamber and the second chamber when the second chamber is at the open position relative to the first chamber, adjusting the angle of the semiconductor wafer, and re-placing the angle-adjusted semiconductor wafer between the first chamber and the second chamber, wherein the re-placed semiconductor wafer is rotated by a predetermined angle relative to the previously placed semiconductor wafer;

A drive and valve assembly, configured to, when the second chamber is at the closed position relative to the first chamber and the semiconductor wafer is accommodated between the first chamber and the second chamber, controls fluid to enter the sealed channel through one of the first through-hole and the second through-hole, wherein the fluid entering the sealed channel is capable of moving forward guided by the sealed channel, the fluid then being able to contact a portion of the surface of the semiconductor wafer, and the fluid flowing over the surface of the semiconductor wafer flowing out through the other of the first through-hole and the second through-hole and being extracted.

According to another aspect of the present disclosure, the present disclosure provides a semiconductor processing method based on the semiconductor processing system described above, comprising: setting the second chamber at the open position relative to the first chamber; under the control of the control unit, the robot performs an angle adjustment operation on a semiconductor wafer located between the first chamber and the second chamber, the angle adjustment operation comprises: picking up the semiconductor wafer located between the first chamber and the second chamber when the second chamber is at the open position relative to the first chamber, adjusting the angle of the semiconductor wafer, and re-placing the angle-adjusted semiconductor wafer between the first chamber and the second chamber, wherein the re-placed semiconductor wafer is rotated by a predetermined angle relative to the previously placed semiconductor wafer; setting the second chamber at the close position relative to the first chamber; injecting a fluid into the recessed groove through one of the first through-hole and the second through-hole, the fluid flowing along the sealed channel until reaching the other of the first through-hole and the second through-hole, and extracting the fluid from this other through-hole.

Compared to existing techniques, in the present disclosure, since the robot can perform the angle adjustment operation on the semiconductor wafer, contaminant impurities in more selected regions of the semiconductor wafer can be extracted and detected.

Therefore, it should be understood that providing this summary is only for the purpose of summarizing some embodiments to offer a basic understanding of some aspects of the present disclosure. Thus, the above embodiments are merely examples and should not be construed as narrowing the scope or spirit of the present disclosure in any way. Through reading the following detailed description and the accompanying drawings, the features, appearance and advantages of each embodiment will be apparent, and the drawings illustrate the principles of some embodiments by way of example.

### BRIEF DESCRIPTION OF THE DRAWINGS

The present disclosure may be better understood by referring to the drawings as well as the detailed description below. In particular, same numerals are used to refer to same structural parts throughout the drawings, and wherein:
FIG. 1a illustrates a cross-section view of a schematic diagram of a semiconductor process device of the present disclosure, according to one embodiment;
FIG. 1b illustrates an enlarge schematic diagram of a circle A shown in FIG. 1a;
FIG. 1c illustrates an enlarge schematic diagram of a circle B shown in FIG. 1a;
FIG. 2a illustrates a top view of a second chamber, according to one embodiment;
FIG. 2b illustrates an enlarge schematic diagram of a circle C shown in FIG. 2a;
FIG. 2c illustrates an enlarge schematic diagram of a circle D shown in FIG. 2a;
FIG. 2d illustrates a cross-section view of the semiconductor wafer along a section line A-A of FIG. 2a;
FIG. 2e illustrates an enlarge schematic diagram of a circle E shown in FIG. 2d.;
FIG. 2f illustrates an enlarge schematic diagram of a circle F shown in FIG. 2a;
FIG. 3a illustrates a top view of a first chamber, according to one embodiment of the present disclosure;
FIG. 3b illustrates an enlarge schematic diagram of a circle G shown in FIG. 3a;
FIG. 3c illustrates an enlarge schematic diagram of a circle H shown in FIG. 3a;
FIG. 3d illustrates a cross-section view of the semiconductor wafer along a section line B-B of FIG. 3a;
FIG. 3e illustrates an enlarge schematic diagram of a circle I shown in FIG. 3d;
FIG. 3f illustrates an enlarge schematic diagram of a circle J shown in FIG. 3a;
FIG. 4a illustrates a cross-section view of a schematic diagram of a semiconductor process device of the present disclosure, according to another embodiment;
FIG. 4b illustrates an enlarge schematic diagram of a circle K shown in FIG. 4a;
FIG. 5a illustrates a top view of a first chamber of the present disclosure, according to one embodiment;
FIG. 5b illustrates a cross-section view of the semiconductor wafer along a section line C-C of FIG. 5a;
FIG. 5c illustrates an enlarge schematic diagram of a circle L shown in FIG. 5a;
FIG 6a illustrates a top view of a second chamber, according to another embodiment of the present disclosure;
FIG. 6b illustrates an enlarge schematic diagram of a circle M shown in FIG. 6a;
FIG. 7 is a flowchart of a semiconductor processing method according to one embodiment of the present disclosure.
FIG. 8 is a schematic diagram of the structure of the semiconductor processing system according to another embodiment of the present disclosure;
FIG. 9 is a flowchart of the semiconductor processing method according to another embodiment of the present disclosure.

### DETAILED DESCRIPTION OF THE PREFERRED EMBODIMENTS

Some embodiments of the present disclosure will be described more fully hereinafter with reference to the accompanying drawings, in which some, but not all embodiments are set forth. Indeed, various embodiments of the present disclosure may be embodied in many different forms and should not be construed as limited to the embodiments set forth herein; rather, these embodiments are provided so that the present disclosure will be thorough and complete, and will fully convey the scope of the present disclosure to the technical personnel in this field. For example, unless otherwise indicated, referring to something as a first, second, etc. should not be construed as implying a particular order. Also, something may be described as being above something else (unless otherwise indicated) but in fact may be below it, and vice versa; similarly, something described as being on the left may be on the right, and vice versa. The same reference numerals always refer to the same elements.

The details of the present disclosure can be more clearly understood with reference to the accompanying drawings and the description of the specific embodiments of the present disclosure. However, the specific embodiments of the present disclosure described herein are only for the purpose of explaining the present disclosure and should not be construed as limiting the present disclosure in any way. Under the teaching of the present disclosure, those skilled in the art can conceive of any possible modifications based on the present disclosure, which should be regarded as falling within the scope of the present disclosure. It should be noted that when an element is referred to as being "disposed on" another element, it can be directly on the other element or intervening elements may also be present. When an element is considered to be "connected" to another element, it can be directly connected to the other element or intervening elements may be present simultaneously. The terms "mounted," "connected," and "coupled" should be understood in a broad sense, for example, it may be a mechanical connection or an electrical connection, or it may be an internal communication between two elements, it may be a direct connection or an indirect connection through an intermediate medium. For those of ordinary skill in the art, the specific meanings of the above terms can be understood according to specific circumstances. The terms "vertical," "horizontal," "upper," "lower," "left," "right" and similar expressions used herein are for illustrative purposes only and do not represent the only embodiments.

Unless otherwise defined, all technical and scientific terms used herein have the same meaning as commonly understood by the technical personnel in this field to which this application belongs. The terms used in the specification of the present application herein are for the purpose of describing specific implementations only and are not intended to limit the present application. The term "and/or" as used herein includes any and all combinations of one or more of the associated listed items.

### Part 1

To better extract and detect contaminant impurities in a wafer, a semiconductor processing device is also proposed in present disclosure.

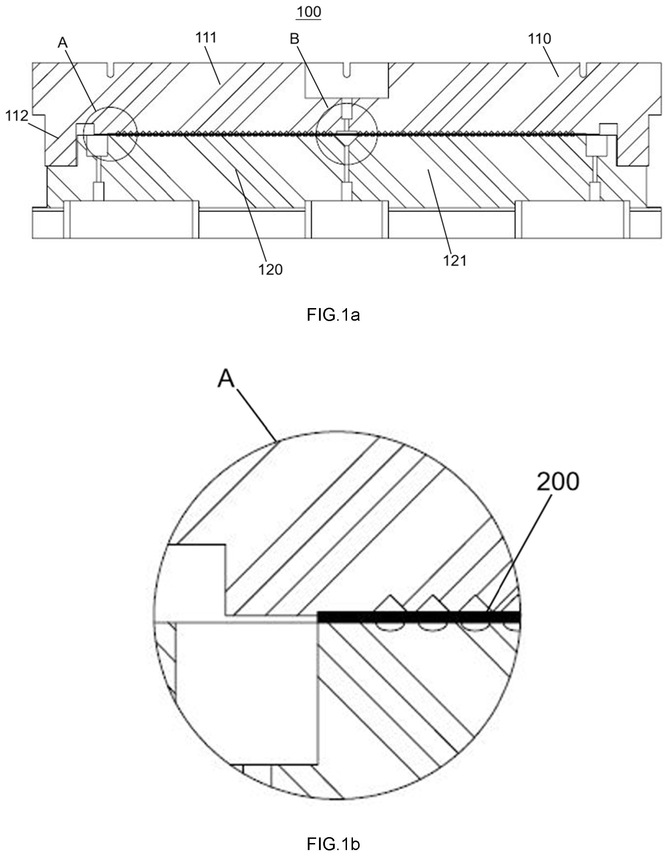

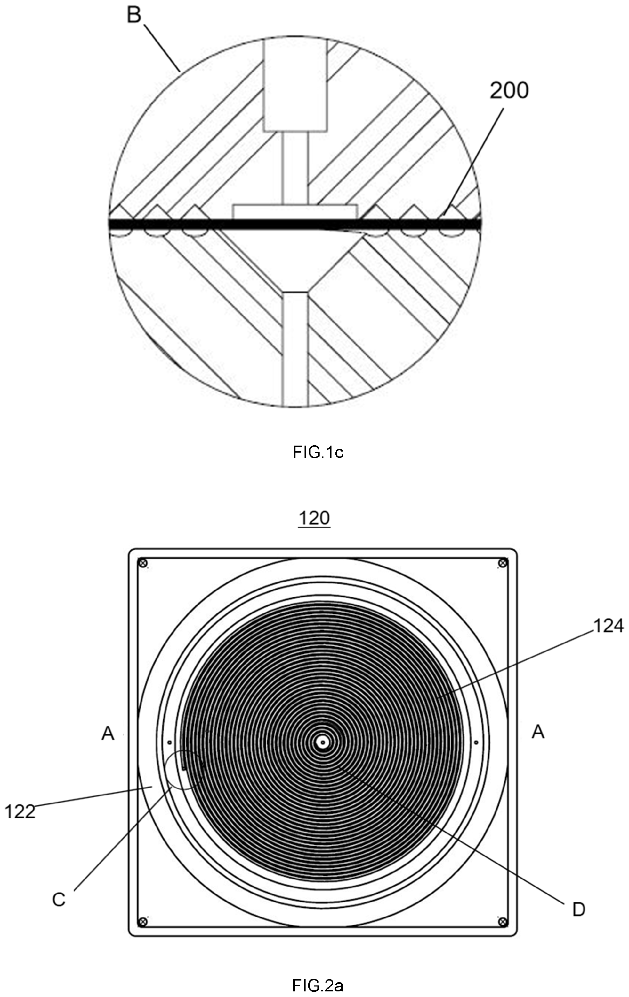

FIG. 1a illustrates a cross-section view of a schematic diagram of a semiconductor process device 100 of the present disclosure, according to one embodiment; FIG. 1b illustrates an enlarge schematic diagram of a circle A shown in FIG. 1a; FIG. 1c illustrates an enlarge schematic diagram of a circle B shown in FIG. 1a; As shown in FIG. 1a, the semiconductor processing device 100 includes a first chamber 110 and a second chamber 120. In this embodiment, the first chamber 110 is the upper chamber, and the second chamber 120 is the lower chamber. In other embodiments, the lower chamber could also be defined as the first chamber, and the upper chamber as the second chamber.

The first chamber 110 comprises an upper chamber board 111 and a first protruding edge 112 extended downward from the periphery of the upper chamber board. The second chamber 120 comprises a lower chamber board 121 and a first recessed groove 122 that dented downward at the periphery of the lower chamber board 121.

The first chamber 110 is movable relative to the second chamber 120 between an open position and a closed position. When the first chamber 110 is at the open position relative to the second chamber 120, a semiconductor wafer to be processed can be placed on or taken out of an inner wall surface of the second chamber 120. When the first chamber 110 is at the closed position relative to the second chamber 120, the first protruding edge 112 cooperates with the first recessed groove 122 to form a sealed micro chamber between the upper and lower chamber boards, accommodating the semiconductor wafer for subsequent process.

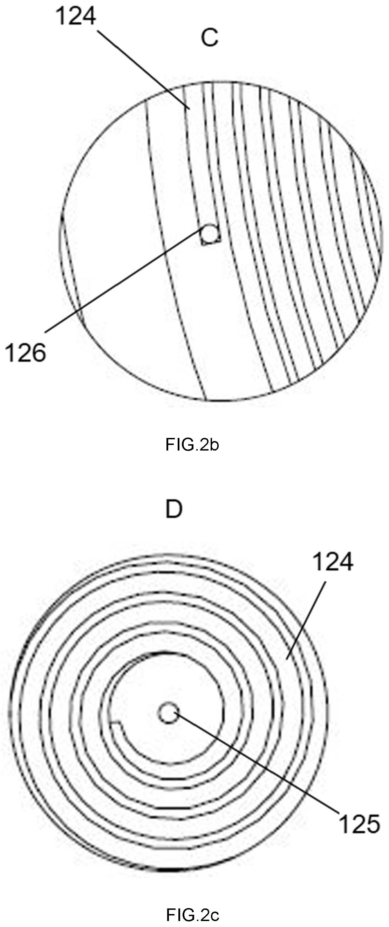

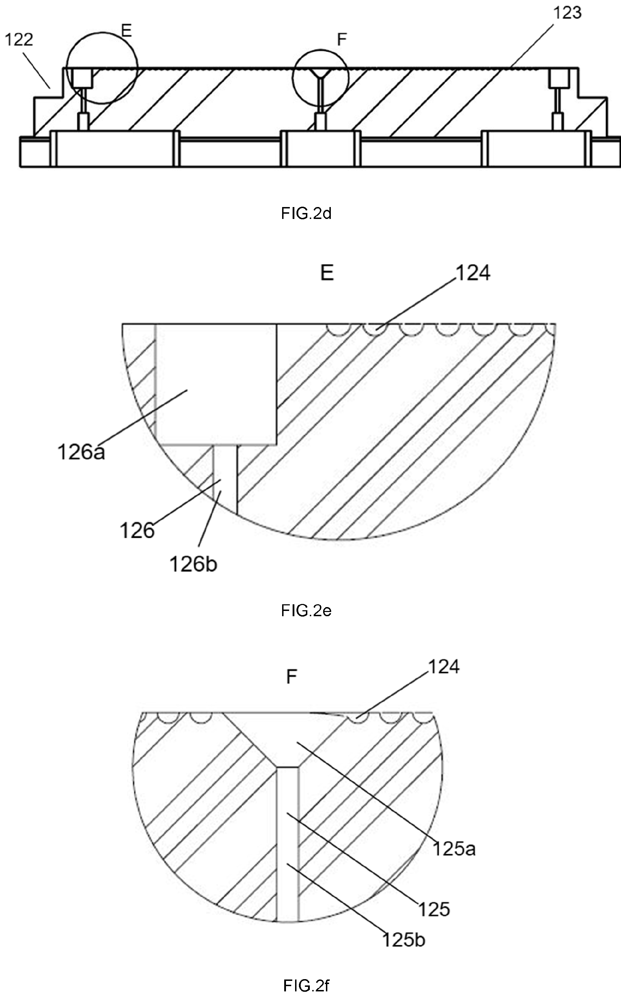

FIG. 2a illustrates a top view of a second chamber, according to one embodiment; FIG. 2b illustrates an enlarge schematic diagram of a circle C shown in FIG. 2a; FIG. 2c illustrates an enlarge schematic diagram of a circle D shown in FIG. 2a; FIG. 2d illustrates a cross-section view of the semiconductor wafer along a section line A-A of FIG. 2a; FIG. 2e illustrates an enlarge schematic diagram of a circle E shown in FIG. 2d; FIG. 2f illustrates an enlarge schematic diagram of a circle F shown in FIG. 2a.

As shown in FIGS. 2a-2f, the second chamber 120 comprises a recessed groove 124 formed by being recessed from the inner wall surface 123 of the second chamber 120 facing the micro chamber, a first through-hole 125 penetrating from the exterior through the second chamber to communicate with a first position of the recessed groove 124, and a second through-hole 126 penetrating from the exterior through the second chamber to communicate with a second position of the recessed groove 124. The cross-section of the recessed groove 124 may be U-shaped, V-shaped, or semicircular, or other shapes. The number of through-holes in the recessed groove 124 may be one or more.

As shown in FIGS. 1a, 1b, and 1c, when the first chamber 110 is at the closed position relative to the second chamber 120 and the semiconductor wafer 200 is accommodated in the micro chamber, one surface (lower surface) of the semiconductor wafer 200 abuts against the inner wall surface 123 forming the recessed groove 124. At this time, the recessed groove 124 forms a sealed channel by the blocking of the surface of the semiconductor wafer 200, and this sealed channel communicates with the exterior through the first through-hole 125 and the second through-hole 126. In application, a processing fluid can enter the sealed channel through the first through-hole 125, and the fluid entering the sealed channel is capable of moving forward guided by the sealed channel. At this time, the processing fluid then being able to contact a portion of the surface of the semiconductor wafer 200, and the fluid flowing over the surface of the semiconductor wafer 200 flowing out through the second through-hole 126 and be extracted. In this way, not only can the flow direction and flow rate of the processing fluid be precisely controlled, but also significantly reduce fluids consumption.

In one embodiment, as shown in FIGS. 2a, 2b, and 2c, the recessed groove 124 rings and forms a spiral shape. The first through-hole 125 is located at the central region (area circled as D) of the spiral recessed groove, and the second through-hole 126 is located at the peripheral region(area circled as C) of the spiral recessed groove124. The first through-hole 125 may serve as an inlet, while the second through-hole 126 serves as an outlet. In other embodiments, the first through-hole 125 may serve as an outlet, while the second through-hole 126 serves as an inlet.

In one embodiment, as shown in FIGS. 2d, 2e, and 2f, the first through-hole 125 comprises a first buffer port 125a which directly connected to the recessed groove 124 and is deeper and wider than the recessed groove 124, and a first through-hole port 125b connected to the first buffer port 125a. The first buffer port 125a can prevent over-treating the central area of the semiconductor wafer from excessive initial flow velocity of the processing fluid. The second through-hole 126 comprises a second buffer port 126a which directly connected to the recessed groove 124 and is deeper and wider than the recessed groove 124, and a first through-hole port 126b connected to the first buffer port 126a. The second buffer port 126a can prevent the processing fluid overflow from the second through-hole 126 due to unable to be discharged in a timely manner. Preferably, the first buffer port 125a may be a tapered recess, while the second buffer port 126a may be a cylindrical recess.

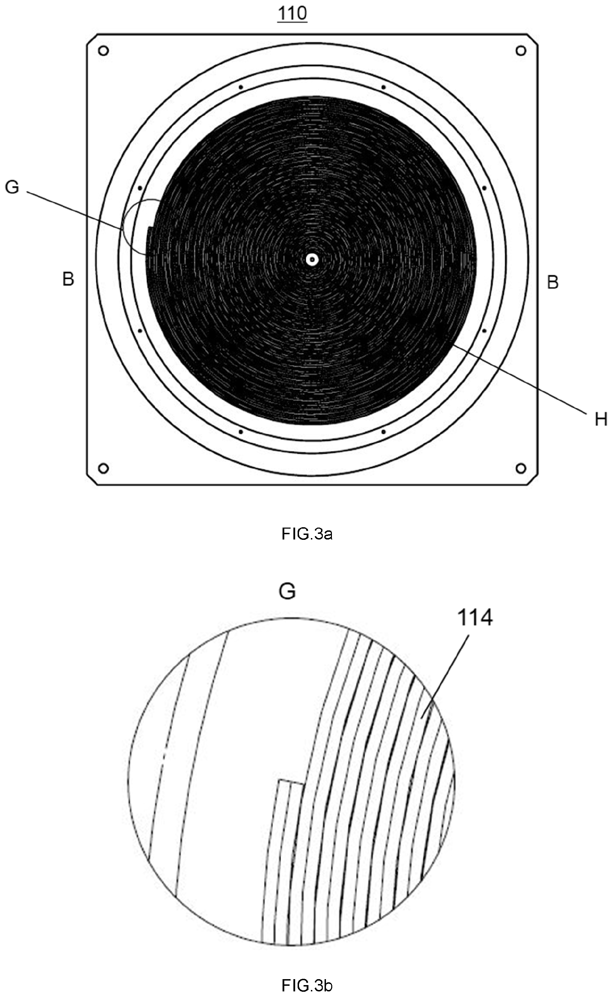

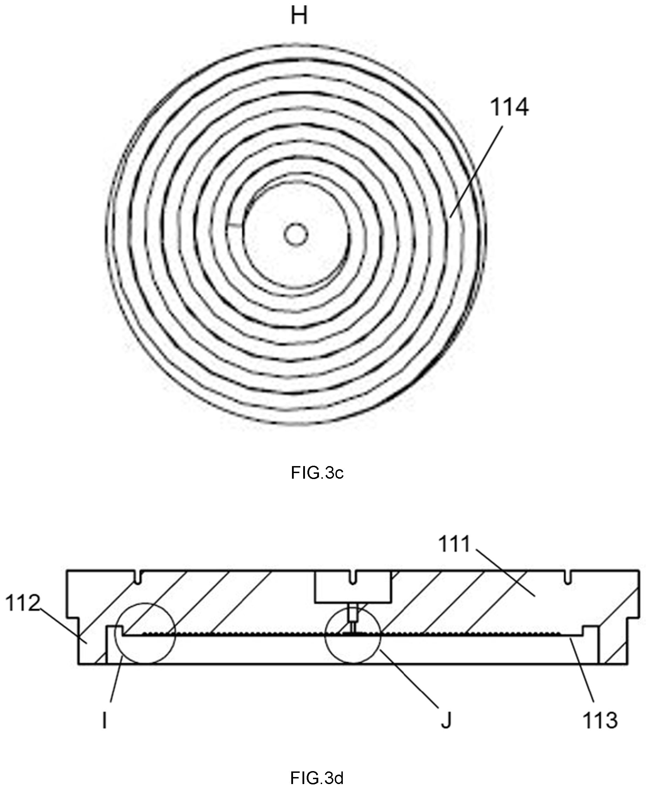

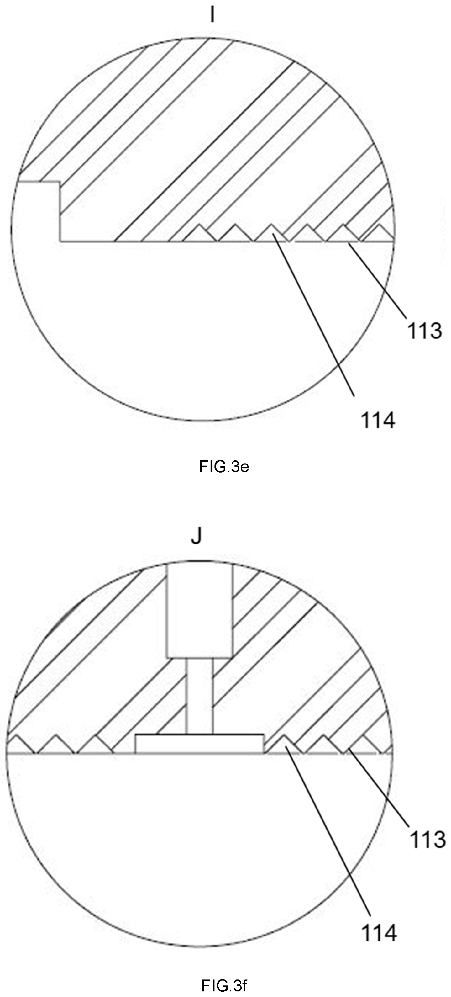

FIG. 3a illustrates a top view of a first chamber, according to one embodiment of the present disclosure; FIG. 3b illustrates an enlarge schematic diagram of a circle G shown in FIG. 3a; FIG. 3c illustrates an enlarge schematic diagram of a circle H shown in FIG. 3a; FIG. 3d illustrates a cross-section view of the semiconductor wafer along a section line B-B of FIG. 3a; FIG. 3e illustrates an enlarge schematic diagram of a circle I shown in FIG. 3d; FIG. 3f illustrates an enlarge schematic diagram of a circle J shown in FIG. 3a.

As shown in FIGS. 3a-3f, the first chamber 110 comprises an upper chamber board 111 and a first protruding edge 112 extended downward from the periphery of the upper chamber board 111. The first chamber 110 comprises a recessed groove 113 formed on an recessed inner wall surface 123 facing the micro chamber. The groove walls (portions between adjacent the recessed groove 114) of the recessed groove 114 which is formed on the inner wall surface 123 of the first chamber 110, align with (FIGS. 1b, 1c) the groove walls (portions between adjacent the recessed groove 124) of the recessed groove 124 which is formed on the inner wall surface 123 of the second chamber 120. In this way, when the first chamber 110 is at the closed position relative to the second chamber 120 and the semiconductor wafer 200 is accommodated in the micro chamber, the groove walls of the recessed groove 114 of the first chamber 110 may be abutted against corresponding positions of the semiconductor wafer 200, ensuring tighter contact with the groove walls of the recessed groove 124 of the second chamber 120. This enhances the sealing performance of the final formed sealed channel. Additionally, the groove walls (portions between adjacent the recessed groove 114) of the recessed groove 114 formed on an inner wall surface 123 of the upper chamber and the groove walls (portions between adjacent the recessed groove 124) of the recessed groove 124 formed on an inner wall surface 123 of the second chamber 120 may be arranged in an alternating pattern.

In another modified embodiment, the structures of the first chamber 110 and the second chamber may be interchangeable or identical. In this case, the upper surface of the semiconductor wafer 200 forms a sealed channel with the recessed groove of the first chamber 110. Processing fluid flowing through the sealed channel can process the upper surface or lower surface, or both surfaces at the same time of the semiconductor wafer 200 to be processed.

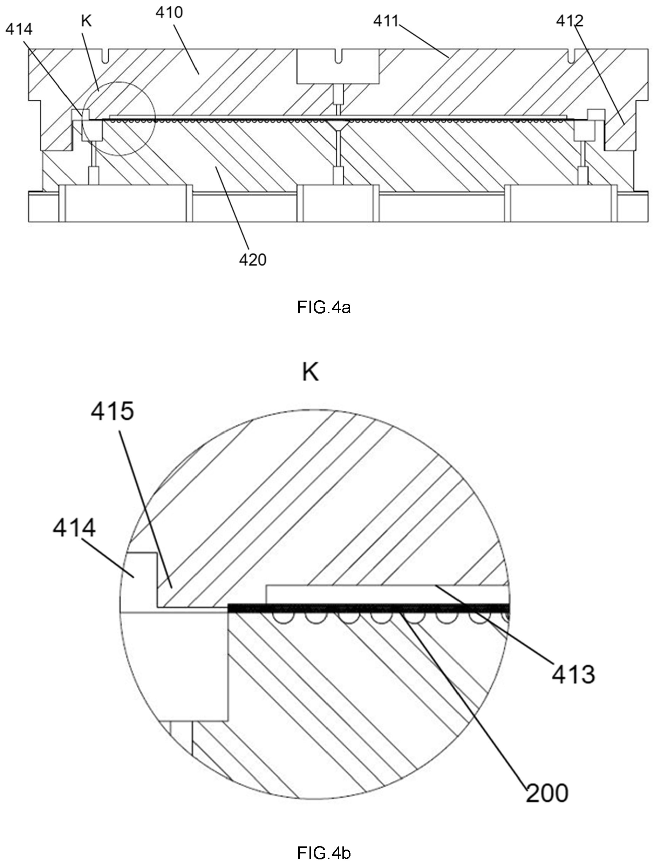

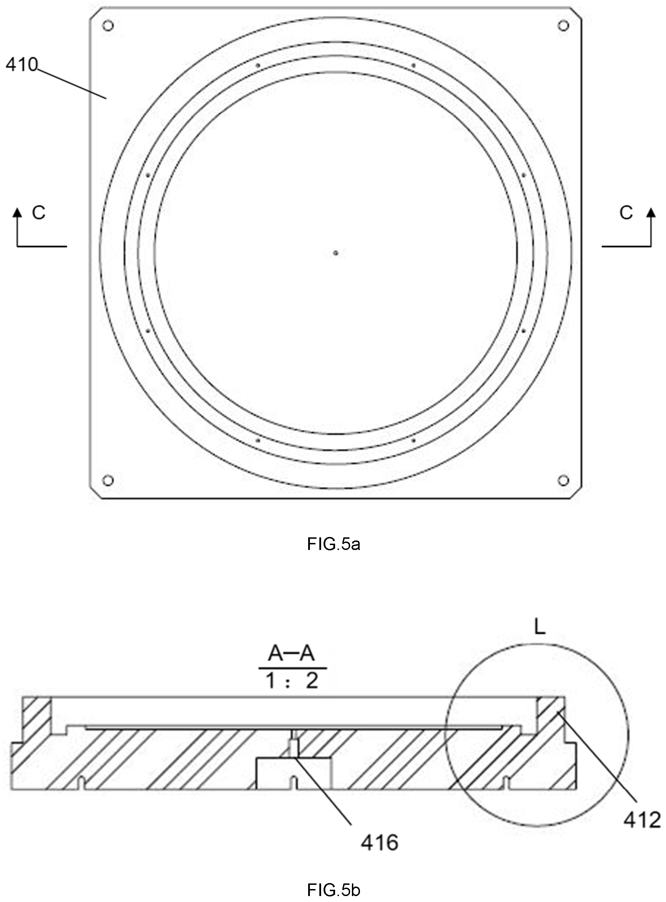

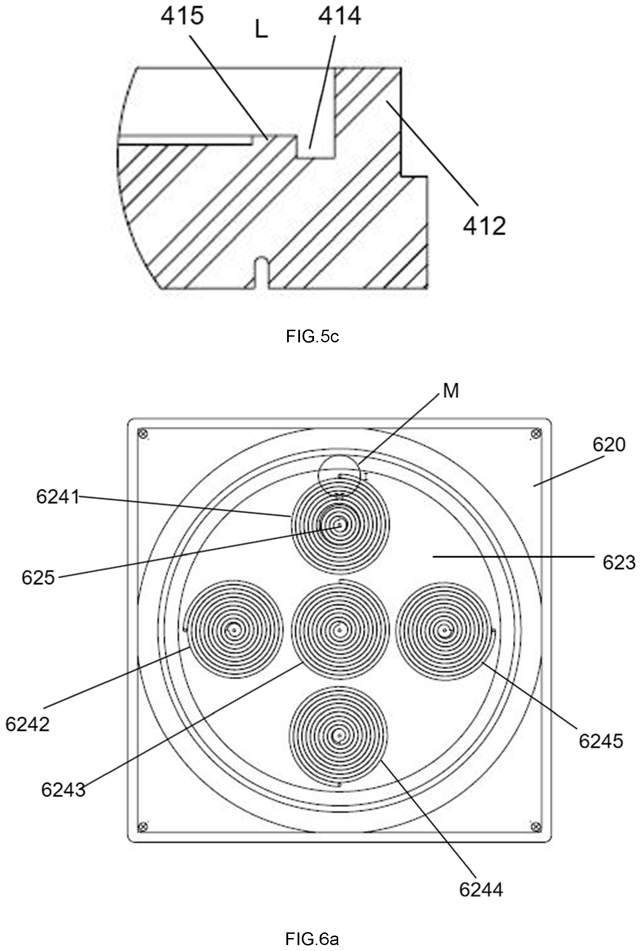

FIG. 4a illustrates a cross-section view of a schematic diagram of a semiconductor process device of the present disclosure, according to another embodiment 200; FIG. 4b illustrates an enlarge schematic diagram of a circle K shown in FIG. 4a. The difference between the device 400 in FIG. 4a and the device in FIG. 1a is that the structure of the first chamber 410 in FIG. 4a differs from the structure of the first chamber 110 in FIG. 1a. FIG. 5a illustrates a top view of a first chamber 410 of the present disclosure, according to one embodiment; FIG. 5b illustrates a cross-section view of the semiconductor wafer along a section line C-C of FIG. 5a; FIG. 5c illustrates an enlarge schematic diagram of a circle L shown in FIG. 5a. As shown in FIGS. 5a-5c, the first chamber 410 comprises an upper chamber board 411, a first protruding edge 412, a first inner wall surface 413 facing the micro chamber, a second recessed groove 414, a second protruding edge 415 between the first inner wall surface 413 and the second recessed groove 414, and a passage 416 at the center of the first inner wall surface 413. The second protruding edge 415 abuts against the semiconductor wafer 200 and the first inner wall surface 413 to form a sealed space, which connects with the exterior through the passage 416. Fluid entering the sealed space through the passage 416 generates pressure, pressing the semiconductor wafer 200 tightly against the groove walls of the recessed groove 124 of the second chamber 120, thereby improving the sealing performance of the final formed sealed channel.

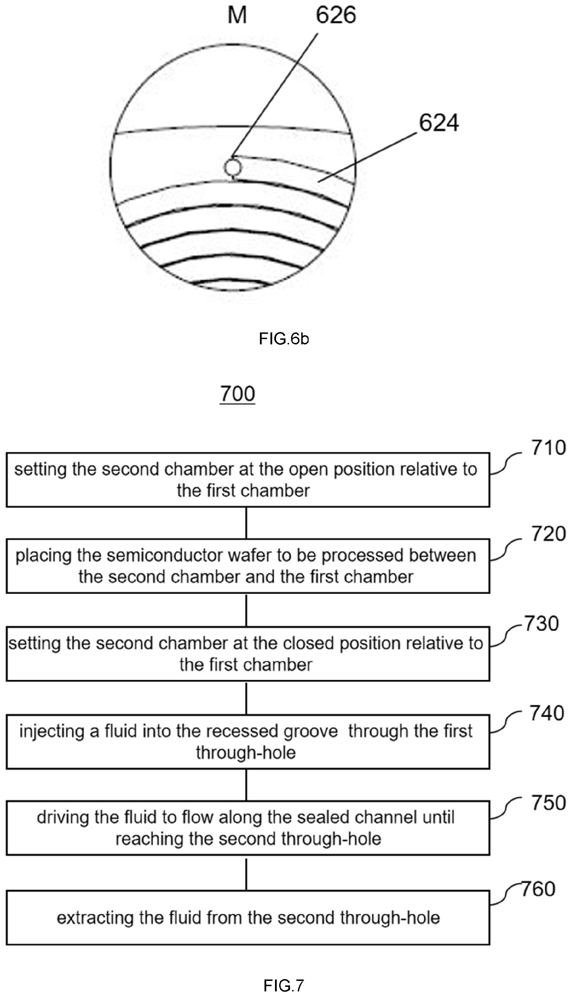

FIG 6a illustrates a top view of a second chamber, according to another embodiment of the present disclosure; FIG. 6b illustrates an enlarge schematic diagram of a circle M shown in FIG. 6a. The recessed grooves 624 formed on the recessed inner wall surface 623 of the second chamber 620 facing the micro chamber are multiple. There are five recessed grooves in FIG 6a, while in other embodiments, it may be other numbers. Each recessed groove 624 corresponds to a first through-hole 625 and a second through-hole 626. The different recessed grooves 624 are distributed in different regions of the inner wall surface 623, which allows for different operations to be performed to different regions, which are independent of each other.

The present disclosure also proposes a semiconductor processing method using the aforementioned device. As shown in FIG. 7, the semiconductor processing method 700 comprises the following steps:
Step 710: setting the second chamber 120 at the open position relative to the first chamber 110;
Step 720: placing the semiconductor wafer to be processed between the second chamber 120 and the first chamber 110;
Step 730: setting the second chamber 120 at the closed position relative to the first chamber 110;
Step 740: injecting a fluid into the recessed groove 124 through the first through-hole 125;
Step 750: driving the fluid to flow along the sealed channel until reaching the second through-hole 126;
Step 760: extracting the fluid from the second through-hole 126.

In one embodiment, elemental detection can be performed based on the extracted fluid, thus obtaining elements remaining on the surface of the semiconductor wafer and their concentrations.

In one embodiment, the fluid is a liquid or a gas, and the fluid is a reactive fluid or an extraction fluid. The reactive fluid is capable of reacting with the contacted surface of the semiconductor wafer. The extraction fluid is capable of extracting contaminant impurities from the contacted surface of the semiconductor wafer.

A driving fluid can be used to drive the fluid to flow in the sealed channel, or a gas pressure, such as a vacuum pump to create a vacuum, can be used to drive the fluid to flow in the sealed channel. The driving fluid is a non-reactive ultra-pure gas or ultra-pure liquid, such as nitrogen, helium, argon, ultra-pure water, acetone, carbon tetrachloride, etc.

In another embodiment, the first through-hole 125 can also serve as a fluid outlet, while the second through-hole 126 serves as a fluid inlet..

### Part 2

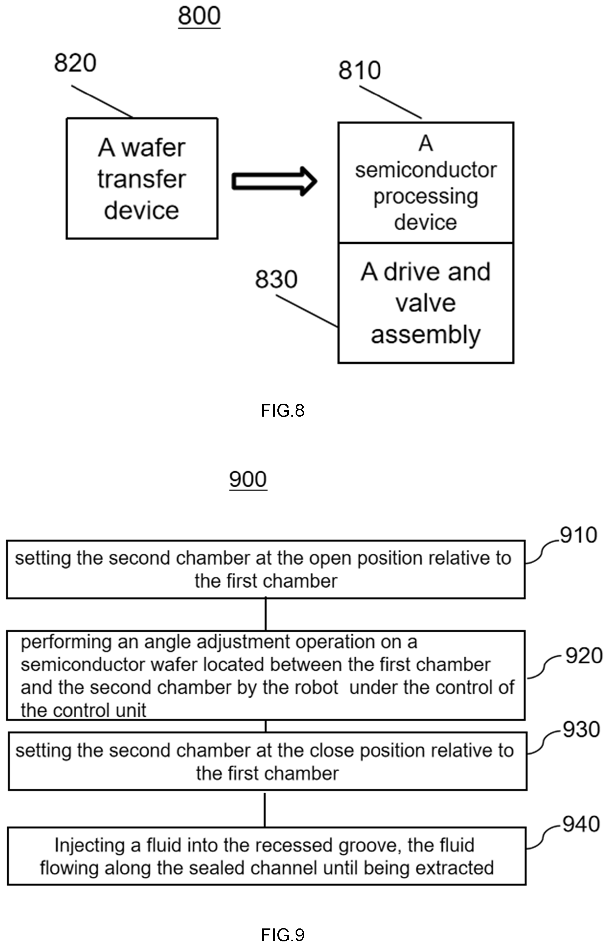

FIG. 8 is a schematic diagram of the structure of the semiconductor processing system according to another embodiment of the present disclosure. As shown in FIG. 8, the semiconductor processing system 600 comprises a semiconductor processing device 810, a wafer transfer device 820, and a driving and valve assembly 830.

The semiconductor processing device 810 can be the semiconductor processing device described in any of the above embodiments. Preferably, the second chamber of the semiconductor processing device 810 is as shown in FIG. 6a.

The wafer transfer device 820 comprises a robot and a control unit. Under the control of the control unit, the robot performs an angle adjustment operation on a semiconductor wafer located between the first chamber and the second chamber. The angle adjustment operation comprises picking up the semiconductor wafer located between the first chamber and the second chamber when the second chamber is at the open position relative to the first chamber, adjusting the angle of the semiconductor wafer, and re-placing the angle-adjusted semiconductor wafer between the first chamber and the second chamber, wherein the re-placed semiconductor wafer being rotated by a predetermined angle relative to the previously placed semiconductor wafer.

A drive and valve assembly 830, when the second chamber is at the closed position relative to the first chamber and the semiconductor wafer is accommodated between the first chamber and the second chamber, controls fluid to enter the sealed channel through one of the first through-hole and the second through-hole, wherein the fluid entering the sealed channel being capable of moving forward guided by the sealed channel, the fluid then being able to contact a portion of the surface of the semiconductor wafer, and the fluid flowing over the surface of the semiconductor wafer flowing out through the other of the first through-hole and the second through-hole and being extracted.

In one embodiment, the recessed grooves are multiple, each recessed groove corresponds to one first through-hole and one second through-hole, different recessed grooves are located in different regions of the inner wall surface, wherein the center of at least one recessed groove is spaced a predetermined distance from the center of the inner wall surface. More specifically, the centers of a plurality of recessed grooves are spaced a predetermined distance from the center of the inner wall surface, wherein the plurality of recessed grooves are uniformly distributed around the center of the inner wall surface, and one recessed groove has its center coincident with the center of the inner wall surface where this one recessed groove is located. Specifically, as shown in FIGS. 6a and 6b, there are five recessed grooves 624, namely 6241, 6242, 6243, 6244, and 6245. The centers of the recessed grooves 6241, 6242, 6244, and 6245 are spaced a predetermined distance from the center of the inner wall surface. The center of the recessed groove 6243 coincides with the center of the inner wall surface where this one recessed groove is located.

In another embodiment, the recessed groove may be one, and the center of this one recessed groove is spaced a predetermined distance from the center of the inner wall surface, and this one recessed groove is located in a partial region of the inner wall surface. For example, as shown in FIGS. 6a and 6b, in a modified embodiment, only one of the five recessed grooves 624 could be retained, such as retaining any one of the recessed grooves 6241, 6242, 6244, and 6245.

Referring to FIG. 6a, after the robot performs the angle adjustment operation on the semiconductor wafer located between the first chamber and the second chamber, the regions on the semiconductor wafer corresponding to the recessed grooves 6241, 6242, 6244, and 6245 change. For example, if the control unit sets the predetermined angle to 45 degrees, then after the robot performs the angle adjustment operation on the semiconductor wafer located between the first chamber and the second chamber, the recessed grooves 6241, 6242, 6244, and 6245 correspond to regions of the semiconductor wafer that have been rotated 45 degrees about its center. At this time, by using the recessed grooves 6241, 6242, 6244, and 6245 again to extract and detect contaminant impurities on the surface of the semiconductor wafer, extraction and detection of contaminant impurities in more selected regions (even any region) of the semiconductor wafer can be achieved as needed.

Obviously, the control unit can set the predetermined angle as needed. The predetermined angle can be any angle, for example, the predetermined angle can be 2 degrees, 5 degrees, 45 degrees, 135 degrees, etc. In one embodiment, under the control of the control unit, the robot can perform multiple angle adjustment operations on the semiconductor wafer located between the first chamber and the second chamber. For example, if the second chamber in FIG. 6a only has the recessed groove 6241, the predetermined angle can be set to 45 degrees, and by repeating the angle adjustment operation eight times, the recessed groove 6241 can traverse all peripheral regions of the semiconductor wafer. After each angle adjustment operation, the driving and valve assembly 830 uses the recessed groove 6241 to perform fluid extraction and detection once, thereby achieving fluid processing of different selected regions of the semiconductor wafer using one recessed groove 6241. Furthermore, if the area of the recessed groove 6241 is small, the predetermined angle can be adjusted smaller, such as 10 degrees, so that the recessed groove 6241 can traverse all peripheral regions of the semiconductor wafer. In other embodiments, the recessed groove may not traverse all regions of the semiconductor wafer.

In one embodiment, under the control of the control unit, the robot also performs a semiconductor wafer loading operation, the semiconductor wafer loading operation comprising: the robot picking up an external (e.g., an external wafer cassette) semiconductor wafer, and placing the semiconductor wafer between the first chamber and the second chamber when the second chamber is at the open position relative to the first chamber; under the control of the control unit, the robot also performs a semiconductor wafer unloading operation, the semiconductor wafer unloading operation comprising: when the second chamber is at the open position relative to the first chamber, the robot picking up the semiconductor wafer from the semiconductor processing device and placing it externally (e.g., into an external wafer cassette).

In one embodiment, different semiconductor wafers can be placed in the micro chamber at different angles by the robot, with the same recessed groove corresponding to different regions of the different semiconductor wafers. When processing each semiconductor wafer, the driving and valve assembly drives the fluid to flow through each recessed groove and extracts it. Detection data for each semiconductor wafer is obtained based on the extracted fluid, and the detection data of the different semiconductor wafers is synthesized to obtain uniformity detection data for the semiconductor wafers. Specifically, taking the second chamber shown in FIG. 6a as an example, for a batch of semiconductor wafers, a first portion of the semiconductor wafers is sequentially placed into the semiconductor processing device at the same angle for contaminant impurity extraction and detection, and a second portion of the semiconductor wafers is rotated by 45 degrees and then sequentially placed into the semiconductor processing device for contaminant impurity extraction and detection. By synthesizing the detection data of the first portion of semiconductor wafers and the detection data of the second portion of semiconductor wafers, uniformity detection data for this batch of semiconductor wafers can be obtained. This can reduce the extraction area for each semiconductor wafer by nearly half, but the detection data from two or more semiconductor wafers can be synthesized to obtain uniformity detection data.

In one embodiment, multiple of the plurality of recessed grooves are selected. When processing one semiconductor wafer, the driving and valve assembly drives a same portion of fluid to sequentially flow through the selected multiple recessed grooves. Specifically, taking the second chamber shown in FIG. 6a as an example, the recessed grooves 6241, 6243, and 6244 are selected for contaminant impurity extraction and detection, the driving and valve assembly can drive the same portion of fluid to sequentially flow through the selected multiple recessed grooves 6241, 6243, and 6244. Specifically, after the fluid flows out from the recessed groove 6241, it is driven again to the recessed groove 6243, and then after flowing out from the recessed groove 6243, it is driven again to the recessed groove 6244, finally, the fluid is extracted and detected to obtain detection data. This allows the same portion of fluid to flow over more and selected surface regions of the semiconductor wafer, improving detection accuracy and detection rate, and providing more options.

In another embodiment, at least one of the plurality of recessed grooves is selected. When processing different semiconductor wafers, the driving and valve assembly drives a same portion of fluid to repeatedly flow through the selected at least one recessed groove. Specifically, taking the second chamber shown in FIG. 6a as an example, the recessed groove 6241 is selected. Then, the driving and valve assembly drives the same portion of fluid to flow through the recessed groove 6241 to perform contaminant impurity extraction on a first semiconductor wafer. Subsequently, the first semiconductor wafer is replaced with a second semiconductor wafer, and the same portion of fluid is again used to flow through the recessed groove 6241 to perform contaminant impurity extraction on the second semiconductor wafer. Then, the second semiconductor wafer is replaced with a third semiconductor wafer, and the same portion of fluid is again used to flow through the recessed groove 6241 to perform contaminant impurity extraction on the third semiconductor wafer. This process is repeated, and finally, the resulting fluid is detected to obtain detection data. This allows for repeated detection of the same region on different semiconductor wafers, improving detection accuracy and detection rate.

In another embodiment, the aforementioned extraction and detection methods may also be combined.

FIG. 9 is a flowchart of the semiconductor processing method according to another embodiment of the present disclosure. The semiconductor processing method comprises the following steps.
Step 910: setting the second chamber at the open position relative to the first chamber;
Step 920: performing an angle adjustment operation on a semiconductor wafer located between the first chamber and the second chamber by the robot under the control of the control unit, the angle adjustment operation comprises: picking up the semiconductor wafer located between the first chamber and the second chamber when the second chamber is at the open position relative to the first chamber, adjusting the angle of the semiconductor wafer, and re-placing the angle-adjusted semiconductor wafer between the first chamber and the second chamber, wherein the re-placed semiconductor wafer being rotated by a predetermined angle relative to the previously placed semiconductor wafer;
Step 930: setting the second chamber at the close position relative to the first chamber;
Step 940: injecting a fluid into the recessed groove through one of the first through-hole and the second through-hole, the fluid flowing along the sealed channel until reaching the other of the first through-hole and the second through-hole, and extracting the fluid from this other through-hole.

In one embodiment, the semiconductor processing method further comprises: under the control of the control unit, the robot also performs a semiconductor wafer loading operation, the semiconductor wafer loading operation comprising: the robot picking up an external semiconductor wafer, and placing the semiconductor wafer between the first chamber and the second chamber when the second chamber is at the open position relative to the first chamber; under the control of the control unit, the robot also performs a semiconductor wafer unloading operation, the semiconductor wafer unloading operation comprising: when the second chamber is at the open position relative to the first chamber, the robot picking up the semiconductor wafer from the semiconductor processing device and placing it externally.

The content of the semiconductor processing method is the same as that of the semiconductor processing system. Please refer to the introduction of the semiconductor processing system for details, it will not be repeated here.

The above description is intended to be illustrative, not restrictive. Although the present disclosure has been described with reference to specific illustrative examples, it should be understood that the present disclosure is not limited to the described embodiments. The scope of the present disclosure should be determined with reference to the appended claims, along with the full scope of equivalents to which such claims are entitled.

The term 'one embodiment' or 'embodiment' referred to here refers to specific features, structures, or characteristics related to the embodiment that can be included in at least one implementation of the present disclosure. The phrase "in one embodiment" appearing in different places in this instruction does not necessarily refer to the same embodiment, nor does it necessarily mean a separate or alternative embodiment that is mutually exclusive with other embodiments. In the present disclosure, "multiple" and "several" refer to two or more. In the present disclosure, "and/or" represents "and" or "or". Additionally, the terms "first," "second," "third," "fourth," etc. used herein are intended as labels to distinguish between different elements, and may not necessarily have an ordinal meaning according to their numerical designation. Therefore, the terminology used herein is for the purpose of describing particular implementations only and is not intended to be limiting.

**It** should also be noted that in some alternative implementations, the functions/acts noted may occur out of the order noted in the figures. For example, two figures shown in succession may in fact be executed substantially concurrently or may sometimes be executed in the reverse order, depending upon the functionality/acts involved.

Although method operations are described in a particular order, it should be understood that other operations may be performed between the described operations. The described operational sequences may be adjusted so that they occur at slightly different times, or the described operations may be distributed in a system. The system allows for simultaneous processing of multiple unrelated programs.

Many modifications and other implementations of the present disclosure will come to mind of those skilled in the art having the benefit of the teachings presented in the foregoing descriptions and the associated drawings. Therefore, it is to be understood that the present disclosure is not to be limited to the specific embodiments disclosed and that modifications and other implementations are intended to be included within the scope of the appended claims. Moreover, although the foregoing description and the associated drawings describe example implementations of element and function combinations, alternative implementations of different combinations of elements and functions are also included within the scope of the appended claims. Different combinations of elements and/or functions than those explicitly described above are also set forth in the appended claims. Although specific terms are employed herein, they are used in a generic and descriptive sense only and not for purposes of limitation.

## Claims

1. A semiconductor processing system, wherein it comprises:
a semiconductor processing device, comprising: a first chamber; and a second chamber movable relative to the first chamber between an open position and a closed position, wherein when the second chamber is at the closed position relative to the first chamber, a micro chamber is formed between the first chamber and the second chamber, and a semiconductor wafer can be accommodated in the micro chamber, and when the second chamber is at the open position relative to the first chamber, the semiconductor wafer can be transferred into or out of the micro chamber; the first chamber and/or the second chamber comprises a recessed groove formed by being recessed from an inner wall surface of the corresponding chamber, a first through-hole penetrating from an exterior through the corresponding chamber to communicate with a first position of the recessed groove, and a second through-hole penetrating from the exterior through the corresponding chamber to communicate with a second position of the recessed groove; wherein when the second chamber is at the closed position relative to the first chamber and the semiconductor wafer is accommodated between the first chamber and the second chamber, a surface of the semiconductor wafer abuts against the inner surface forming the recessed groove, and the recessed groove forms a sealed channel by blocking of a surface of the semiconductor wafer, the sealed channel communicating with the exterior through the first through-hole and the second through-hole;
a wafer transfer device comprising a robot and a control unit, wherein under control of the control unit, the robot performs an angle adjustment operation on the semiconductor wafer located between the first chamber and the second chamber, the angle adjustment operation comprises: picking up the semiconductor wafer located between the first chamber and the second chamber when the second chamber is at the open position relative to the first chamber, adjusting an angle of the semiconductor wafer, and re-placing the angle-adjusted semiconductor wafer between the first chamber and the second chamber, wherein the re-placed semiconductor wafer is rotated by a predetermined angle relative to the previously placed semiconductor wafer; and;
a drive and valve assembly, configured to, when the second chamber is at the closed position relative to the first chamber and the semiconductor wafer is accommodated between the first chamber and the second chamber, control fluid to enter the sealed channel through one of the first through-hole and the second through-hole, wherein the fluid entering the sealed channel is capable of moving forward guided by the sealed channel, the fluid then being able to contact a portion of the surface of the semiconductor wafer, and the fluid flowing over the surface of the semiconductor wafer flowing out through the other of the first through-hole and the second through-hole and being extracted.

2. The semiconductor processing system according to claim 1, wherein:
the recessed groove is one, and a center of this one recessed groove is spaced a predetermined distance from a center of the inner wall surface, and this one recessed groove is located in a partial region of the inner wall surface; or
the recessed grooves are multiple, each recessed groove corresponds to one first through-hole and one second through-hole, different recessed grooves are located in different regions of the inner wall surface, wherein the center of at least one recessed groove is spaced a predetermined distance from the center of the inner wall surface.

3. The semiconductor processing system according to claim 2, wherein the centers of a plurality of recessed grooves are spaced a predetermined distance from the center of the inner wall surface, wherein the plurality of recessed grooves are uniformly distributed around the center of the inner wall surface,
and one recessed groove has its center coincident with the center of the inner wall surface where this one recessed groove is located.

4. The semiconductor processing device according to claim 2, wherein each recessed groove forms a spiral shape, wherein the first through-hole is located in a central region of the spiral-shaped recessed groove, and the second through-hole is located in a peripheral region of the spiral-shaped recessed groove.

5. The semiconductor processing system according to claim 1, wherein
under the control of the control unit, the robot also performs a semiconductor wafer loading operation, the semiconductor wafer loading operation comprising: picking up an external semiconductor wafer, and placing the semiconductor wafer between the first chamber and the second chamber by the robot when the second chamber is at the open position relative to the first chamber;
under the control of the control unit, the robot also performs a semiconductor wafer unloading operation, the semiconductor wafer unloading operation comprising: picking up the semiconductor wafer from the semiconductor processing device and placing it externally by the robot when the second chamber is at the open position relative to the first chamber.

6. The semiconductor processing system according to claim 1, wherein the control unit is capable of setting the predetermined angle, and
under the control of the control unit, the robot performs one or more angle adjustment operations on the semiconductor wafer located between the first chamber and the second chamber.

7. The semiconductor processing system according to claim 2, wherein different semiconductor wafers are placed in the micro chamber at different angles by the robot, the same recessed groove corresponding to different regions of the different semiconductor wafers, and
when processing each semiconductor wafer, the driving and valve assembly drives the fluid to flow through each recessed groove to extract, obtaining detection data for each semiconductor wafer based on the extracted fluid, and synthesizing the detection data of the different semiconductor wafers to obtain uniformity detection data for the semiconductor wafers.

8. The semiconductor processing system according to claim 2, wherein
multiple of the plurality of recessed grooves are selected, and when processing one semiconductor wafer, the driving and valve assembly drives a same portion of fluid to sequentially flow through the selected multiple recessed grooves; or
at least one of the plurality of recessed grooves is selected, and when processing different semiconductor wafers, the driving and valve assembly drives a same portion of fluid to repeatedly flow through the selected at least one recessed groove.

9. The semiconductor processing system according to claim 1, wherein
the fluid is a liquid or a gas, and the fluid is a reactive fluid or an extraction fluid,
the reactive fluid is capable of reacting with the contacted surface of the semiconductor wafer,
the extraction fluid is capable of extracting contaminant impurities from the contacted surface of the semiconductor wafer.

10. The semiconductor processing method for a semiconductor processing system, the semiconductor system comprising a semiconductor processing device, a wafer transfer device and a driving and valve assembly,
the semiconductor processing device, comprising: a first chamber; and a second chamber movable relative to the first chamber between an open position and a closed position, wherein when the second chamber is at the closed position relative to the first chamber, a micro chamber is formed between the first chamber and the second chamber, and a semiconductor wafer can be accommodated in the micro chamber, and when the second chamber is at the open position relative to the first chamber, the semiconductor wafer can be transferred into or out of the micro chamber; the first chamber and/or the second chamber comprises a recessed groove formed by being recessed from an inner wall surface of the corresponding chamber, a first through-hole penetrating from an exterior through the corresponding chamber to communicate with a first position of the recessed groove, and a second through-hole penetrating from the exterior through the corresponding chamber to communicate with a second position of the recessed groove; wherein when the second chamber is at the closed position relative to the first chamber and the semiconductor wafer is accommodated between the first chamber and the second chamber, a surface of the semiconductor wafer abuts against the inner surface forming the recessed groove, and the recessed groove forms a sealed channel by the blocking of the surface of the semiconductor wafer, the sealed channel communicating with the exterior through the first through-hole and the second through-hole; the wafer transfer device comprising a robot and a control unit,
the semiconductor processing method comprising:
setting the second chamber at the open position relative to the first chamber;
performing an angle adjustment operation on a semiconductor wafer located between the first chamber and the second chamber by the robot under the control of the control unit, the angle adjustment operation comprising:
picking up the semiconductor wafer located between the first chamber and the second chamber when the second chamber is at the open position relative to the first chamber,
adjusting the angle of the semiconductor wafer, and
re-placing the angle-adjusted semiconductor wafer between the first chamber and the second chamber, wherein the re-placed semiconductor wafer is rotated by a predetermined angle relative to the previously placed semiconductor wafer;
setting the second chamber at the close position relative to the first chamber; and
injecting a fluid into the recessed groove through one of the first through-hole and the second through-hole, the fluid flowing along the sealed channel until reaching the other of the first through-hole and the second through-hole, and extracting the fluid from this other through-hole.

11. The semiconductor processing method according to claim 10, further comprising:
performing a semiconductor wafer loading operation by the robot under the control of the control unit, the semiconductor wafer loading operation comprising: picking up an external semiconductor wafer, and placing the semiconductor wafer between the first chamber and the second chamber by the robot when the second chamber is at the open position relative to the first chamber;
performing a semiconductor wafer unloading operation by the robot under the control of the control unit, the semiconductor wafer unloading operation comprising: picking up the semiconductor wafer from the semiconductor processing device and placing it externally by the robot when the second chamber is at the open position relative to the first chamber.

12. The semiconductor processing method according to claim 10, wherein:
the recessed groove is one, and the center of this one recessed groove is spaced a predetermined distance from the center of the inner wall surface, and this one recessed groove is located in a partial region of the inner wall surface; or
the recessed grooves are multiple, each recessed groove corresponds to one first through-hole and one second through-hole, different recessed grooves are located in different regions of the inner wall surface, wherein the center of at least one recessed groove is spaced a predetermined distance from the center of the inner wall surface.

13. The semiconductor processing method according to claim 10, wherein the control unit is capable of setting the predetermined angle,
and under the control of the control unit, the robot performs one or more angle adjustment operations on the semiconductor wafer located between the first chamber and the second chamber.

14. The semiconductor processing method according to claim 12, wherein different semiconductor wafers are placed in the micro chamber at different angles by the robot, the same recessed groove corresponding to different regions of the different semiconductor wafers,
and when processing each semiconductor wafer, the driving and valve assembly drives the fluid to flow through each recessed groove to extract, obtaining detection data for each semiconductor wafer based on the extracted fluid, and synthesizing the detection data of the different semiconductor wafers to obtain uniformity detection data for the semiconductor wafers.

15. The semiconductor processing method according to claim 12, wherein
multiple of the plurality of recessed grooves are selected, and when processing one semiconductor wafer, the driving and valve assembly drives a same portion of fluid to sequentially flow through the selected multiple recessed grooves; or
at least one of the plurality of recessed grooves is selected, and when processing different semiconductor wafers, the driving and valve assembly drives a same portion of fluid to repeatedly flow through the selected at least one recessed groove.
